# EUROPEAN PATENT APPLICATION

(11) **EP 0 703 477 A1**
(43) Date of publication of application: **27.03.1996**
(21) Application number: 95402115.0
(22) Date of filing: 20.09.1995
(51) Int. Cl.: G02B 6/43, H05K 1/14

(54) **Connection system between daughter boards**

(30) Priority: 21.09.1994 FR 9411246
(71) Applicant: AMPHENOL SOCAPEX, F-92400 Courbevoie (FR)
(72) Inventor: Pouyez, Philippe, F-95100 Argenteuil (FR); Kayoun, Pierre, F-92100 Boulogne (FR)
(74) Representative: Dronne, Guy

(57) **Abrégé**

L'invention concerne un système de connexion optique entre des cartes filles (10, 12, 14). Au lieu que la totalité des connexions optiques passent par la carte mère (16) via les embases (18 à 22) et les fiches (24, 28), une partie des connexions électriques est réalisée directement entre les fiches (39, 39') ou les embases (44, 44'). D'autres connexions peuvent être réalisées directement entre les cartes filles.

## Description

La présente invention a pour objet un système de transmission de signaux électriques et/ou optiques entre au moins deux cartes filles.

De façon plus précise, l'invention concerne en particulier en un système de transmission de signaux optiques entre au moins deux cartes filles, le système comprenant une carte mère présentant au moins deux embases pour établir des liaisons optiques avec au moins deux fiches associées aux cartes filles afin d'établir les transmissions de signaux optiques entre lesdites cartes filles.

Dans les appareils ou installations comportant un très grand nombre de composants électroniques ou électriques, ceux-ci sont le plus souvent montés sur des cartes dites filles, c'est-à-dire des supports isolants rigides comportant des pistes conductrices pour relier entre eux les différents composants montés sur une même carte.

Pour interconnecter les différentes cartes filles entre elles, c'est-à-dire pour interconnecter les différents circuits réalisés sur les différentes cartes, on utilise en généralement une carte dite mère. Cette carte est fixée horizontalement dans un support mécanique dit tiroir, la liaison se faisant classiquement par l'intermédiaire de la carte mère.

Pour répondre à des besoins particuliers, par exemple immunité vis-à-vis de phénomènes parasites externes, on développe des appareils ou installations qui comportent pour la transmission de signaux ou d'énergie des composants optiques ou optoélectroniques et des éléments conducteurs de la lumière pour interconnecter ces composants. Un autre intérêt de la transmission optique des signaux est qu'elle permet de réduire très significativement le temps de transit. Le plus souvent dans de telles installations ou appareils, on trouve des connexions électriques de type classique et certaines connexions de type optique. Dans ces systèmes qui commencent à se développer la disposition classique consiste à prévoir un certain nombre de cartes filles comportant les composants optiques ou optoélectroniques et les éléments de transmission optiques entre ces composants et une carte mère sur laquelle sont enfichées mécaniquement les cartes filles, la transmission des signaux optiques se faisant par l'intermédiaire de conducteurs optiques montés dans la carte mère, ces conducteurs optiques étant reliés à des connecteurs optiques montés dans le fond du tiroir contenant la carte mère. En d'autres termes, la totalité des liaisons optiques inter cartes filles se fait par l'intermédiaire de connecteurs associés à la carte mère.

Cependant, devant l'augmentation de la densité des composants optiques ou électro-optiques, et donc devant l'augmentation des connexions optiques à réaliser, c'est la carte mère qui supporte les embases qui recevront elles-mêmes les éléments de connexion des fiches associées aux cartes filles, ce qui représente une limite à l'accroissement du niveau d'intégration dans l'installation dont elle fait partie. Dans les conditions actuelles, l'accroissement de la densité d'interconnexion d'un tiroir optique ou électro-optique consiste à ajouter des connecteurs optiques dans les fiches et les embases par miniaturisation de ceux-ci. Cependant, on ne peut dépasser une certaine densité de ces connecteurs optiques. Ainsi, la carte mère servant au transit des signaux optiques entre les différentes cartes filles devient un élément de moins en mois fiable sur le plan de la transmission des signaux électriques et optiques et en outre de plus en plus coûteux du fait de sa grande complexité.

On voit donc qu'il existe un réel besoin de fournir un mode amélioré d'interconnexions de cartes filles comportant des composants optiques ou électro-optiques à l'aide d'une carte mère dans un double but : soit, pour une densité donnée de composants, de permettre de diminuer la densité des connexions optiques sur la carte mère, afin d'améliorer les caractéristiques qui ont été explicitées précédemment, soit, en maintenant le même niveau de qualité des caractéristiques énoncées précédemment, d'accroître encore la densité de connexion des circuits des cartes filles.

Il faut encore ajouter que le plus souvent on trouve sur les cartes filles non seulement des composants optiques ou optoélectroniques mais également des composants électriques ou électroniques qu'il faut donc interconnecter via la carte mère. Les éléments de connexion électrique entre les fiches et les embases occupent déjà une place importante qui n'est plus disponible bien sûr pour réaliser les connexions optiques.

Un objet de la présente invention est de fournir un système d'interconnexion de cartes filles comportant des composants optiques ou optoélectroniques et éventuellement des composants électroniques qui permette d'obtenir les résultats énoncés ci-dessus.

Pour atteindre ce but, selon l'invention, le système de transmission de signaux électriques et/ou optiques entre au moins deux cartes filles comprenant une carte mère présentant au moins deux embases pour établir des liaisons électriques et/ou optiques avec au moins deux fiches associées auxdites cartes filles afin d'établir des transmissions de signaux électriques et/ou optiques entre lesdites cartes filles via ladite carte mère et la solidarisation mécanique des cartes filles sur la carte mère, se caractérise en ce qu'il comprend en outre des moyens optiques additionnels pour établir des chemins optiques additionnels pour la transmission directe de signaux optiques entre au moins deux éléments choisis dans le groupe comprenant : deux fiches, deux embases, deux cartes filles, une embase et une fiche, une carte fille et la carte mère, par quoi les moyens optiques additionnels établissent entre au moins deux cartes filles une transmission de signaux optiques ne passant pas par ladite carte mère.

On comprend que, grâce à l'adjonction des moyens optiques additionnels, on établit entre les cartes filles au moins certains chemins optiques qui permettent la transmission de signaux électriques ne passant pas par la carte mère. On réalise ainsi une augmentation du nombre de connexions optiques en gardant la même densité de connexion optique directe entre la carte mère et les cartes filles ou on peut diminuer cette densité tout en conservant le même nombre total de connexion optiques.

Selon un premier mode de mise en oeuvre, les moyens optiques additionnels comprennent des moyens pour établir au moins une liaison optique dans chaque fiche de carte fille et des moyens pour établir au moins une liaison optique entre deux embases.

Selon un autre mode de mise en oeuvre, les moyens optiques additionnels comprennent des moyens pour établir au moins un chemin optique dans chaque embase de la carte mère et des moyens pour établir au moins un chemin optique direct entre deux fiches.

Selon un mode préféré de mise en oeuvre, au moins une partie du matériau isolant d'une fiche est conducteur de la lumière et ladite fiche comporte des composants optiques localisés pour établir au moins un chemin optique dans ladite fiche.

Selon un autre mode de mise en oeuvre, au moins une partie du matériau isolant électrique d'une embase est conducteur de la lumière et ladite embase comporte au moins un composant optique localisé pour établir au moins un chemin optique dans ladite embase.

D'autres caractéristiques et avantages de la présente invention apparaîtront mieux à la lecture de la description qui suit de plusieurs modes de réalisation de l'invention donnés à titre d'exemples non limitatifs. La description se réfère aux figures annexées sur lesquelles:
- la figure 1 est une vue générale montrant l'établissement de connexions optiques supplémentaires entre plusieurs cartes filles;
- la figure 2 est une vue montrant plus particulièrement l'établissement des liaisons optiques supplémentaires par l'intermédiaire des embases de la carte mère;
- la figure 3 est une vue montrant un mode d'établissement de connexions optiques supplémentaires par l'intermédiaire des fiches des cartes filles ;
- les figures 4 et 5 illustrent des réseaux de connexions optiques respectivement dans les embases de la carte mère ou dans les fiches des cartes filles ;
- la figure 6 montre d'une part un mode de réalisation de conducteur optique dans la carte fille elle-même et de liaison directe entre deux cartes filles ;
- la figure 7 montre un mode de liaison électrique directe entre une carte fille et la carte mère ; et
- la figure 8 illustre un mode d'utilisation d'éléments de protection physique des extrémités des conducteurs optiques.

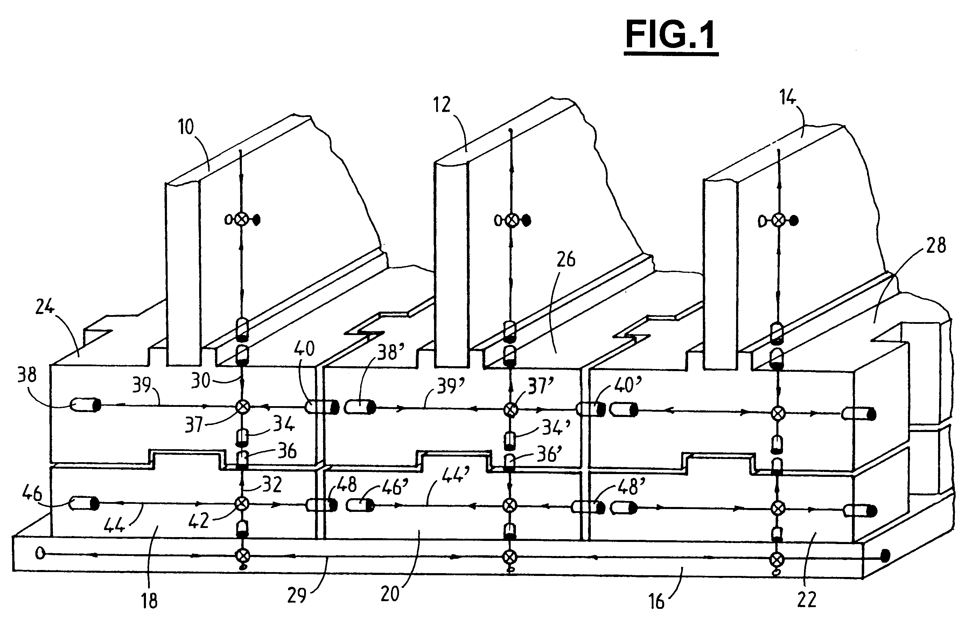

En se référant tout d'abord à la figure 1, on va décrire un premier exemple complet de réalisation du système de transmission de signaux optiques selon l'invention. Sur cette figure, on a représenté d'une part des cartes filles référencées 10, 12, 14 et d'autre part une carte mère 16. La carte mère 16 comporte plusieurs embases, trois dans le cas de l'exemple de la figure 1, ces embases étant respectivement référencées 18, 20 et 22. De même, chaque carte fille 10 à 14 est reliée mécaniquement à une fiche, les fiches portant les références 24, 26 et 28.

Comme on l'a déjà indiqué précédemment dans un système classique, les liaisons optiques entre les cartes filles 10 à 14 se font par l'intermédiaire de conducteurs optiques tels 29 prévus dans la carte mère 16 et de connexions optiques entre les fiches 24 à 26 des cartes filles et les embases 18 à 22 de la carte mère.

Comme on l'a indiqué, selon une caractéristique essentielle de l'invention, les liaisons optiques entre les cartes filles, et plus précisément entre les composants optiques ou optoélectroniques des cartes filles, sont également réalisées par des connexions électriques et optiques additionnelles ne passant pas par la carte mère. Par exemple, si l'on considère la carte fille 10 et sa fiche associée 24, on voit que dans la fiche 24 il existe un trajet optique 30 qui est relié à un trajet optique 32 dans l'embase 18 par des connecteurs optiques 34 et 36. Le trajet optique 30 croise par le composant optique 37 un autre trajet optique 39 interne à la fiche 24 qui comporte à ses extrémités des connecteurs optiques tels que 38 et 40. De même, dans l'embase 18, on trouve sur le trajet optique 32 un composant optique 42 qui définit un croisement avec un autre trajet optique 44 défini dans l'embase 18. Ce trajet optique 44 comporte à ses extrémités, c'est-à-dire dans les faces externes de l'embase 18, des coupleurs optiques 46 et 48.

Si l'on considère la fiche 26 associée à la carte fille 12 et l'embase 20 de la carte mère associée à cette même carte fille, on retrouve, dans cet exemple, exactement la même disposition de chemins optiques qui porte les mêmes références avec le signe '.

On comprend donc que grâce à la connexion optique entre les coupleurs optiques 38 et 40'', on peut réaliser une connexion directe entre les chemins optiques 30 et 30' qui passent directement par les fiches 24 et 26 via les chemins optiques 36 et 36'. De même, on réalise une connexion directe optique entre les embases 18 et 20, via les chemins optiques 4' et 44'.

La figure 1 montre que de la même manière on peut réaliser des liaisons optiques directes entre les chemins optiques 30' liés à la carte fille 12 et les chemins optiques 30'' liés à la carte fille 14 via les fiches et les embases. Sur cette figure 1, on a également représenté des conducteurs optiques 41 et 43 réalisés dans les cartes filles 10 et 12. Ces conducteurs optiques sont reliés à des éléments conducteurs optiques 45 et 47 qui débouchent respectivement dans les faces principales des cartes filles. Une transmission de signaux optiques directement entre les cartes filles 10 et 12 est ainsi rendue possible via l'air interposé entre les deux cartes filles.

Il faut également comprendre que la figure 1 montre les différentes connexions optiques dans le plan de la figure. Il va de soi que, selon la direction X perpendiculaire au plan de la figure, différentes connexions optiques pourraient être réalisées directement entre les embases ou entre les fiches dans des plans différents et que, de plus, dans ces fiches ou dans ces embases, on pourrait réaliser des connexions directes optiques entre les connexions réalisées dans les différents plans parallèles au plan de la figure 1.

Les chemins optiques, aussi bien dans les embases que dans les fiches, peuvent être réalisés par différents moyens. On peut prévoir qu'une partie du matériau isolant électrique constituant les fiches ou les embases comporte une partie conductrice de la lumière. On peut prévoir également simplement des perçages rectilignes dans les embases, on peut prévoir de noyer dans les embases ou dans les fiches des conducteurs optiques ou des fibres optiques. Les connecteurs optiques tels que 38 ou 36 disposés aux extrémités des chemins optiques et donc disposés dans les faces externes des embases ou des fiches peuvent être soit des connecteurs optiques proprement dits, soit des systèmes optiques par lentille de focalisation, soit tout simplement consister dans l'extrémité du conducteur optique. De même, à l'intérieur des fiches ou des embases, on peut prévoir des composants optiques localisés tels que 37 ou 42 à des points de croisement de trajets optiques. Ces composants optiques localisés peuvent être soit passifs et consister par exemple en l'équivalent de séparateurs de faisceaux par miroir semi-réfléchissant, ou, comme on l'expliquera ultérieurement, consister en des éléments optiques dynamiques permettant par commande mécanique ou, de préférence, par commande électronique de modifier, en ces points de croisement, le trajet du faisceau lumineux en fonction de la commande appliquée.

Comme le montre la figure 1, chaque carte fille 10, 12, 14 est solidaire mécaniquement de la fiche correspondante et, comme le montre également la figure, des formes particulières sont prévues entre les embases 18 à 22 et les fiches 24 à 28 afin d'en assurer la liaison mécanique. Sur cette figure, on a représenté uniquement les chemins optiques d'interconnexion entre les composants des cartes filles 10 et 14. Il va de soi que, par des techniques classiques, on peut prévoir également des connexions électriques entre les cartes filles et la carte mère 16 ou des connexions électriques directes entre deux cartes filles via les fiches ou les embases correspondantes.

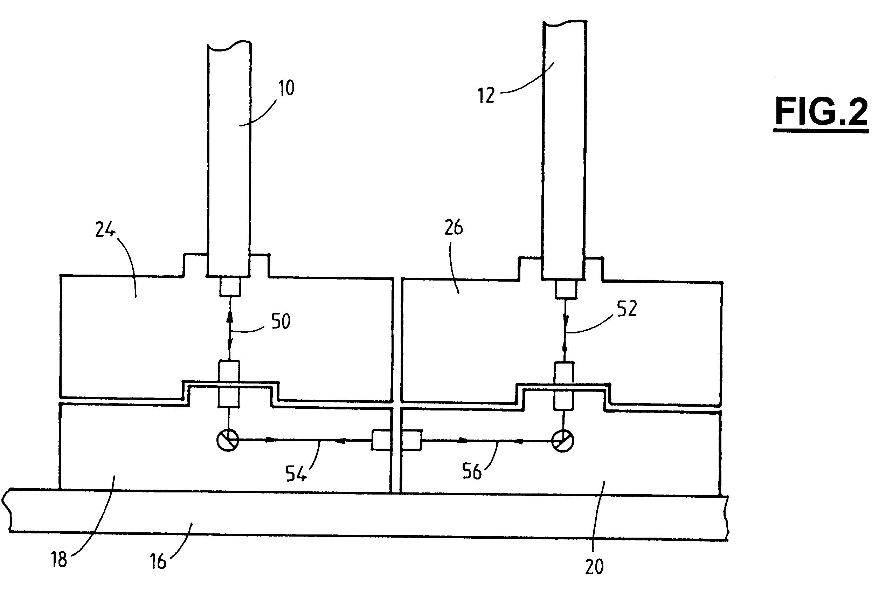

La figure 2 illustre une liaison directe entre les composants optiques ou électro-optiques de deux cartes filles 10 et 12 via les embases associées 18 et 20 de la carte mère 16. Comme on l'avait décrit succinctement précédemment, les chemins optiques principaux 50 et 52 dirigés vers les cartes filles 10 et 12 et traversant, d'une part, la fiche 24 et l'embase 18 et, d'autre part, la fiche 26 et l'embase 20 sont reliés entre eux par un trajet optique 54, 56 ménagé directement dans les embases 18 et 20.

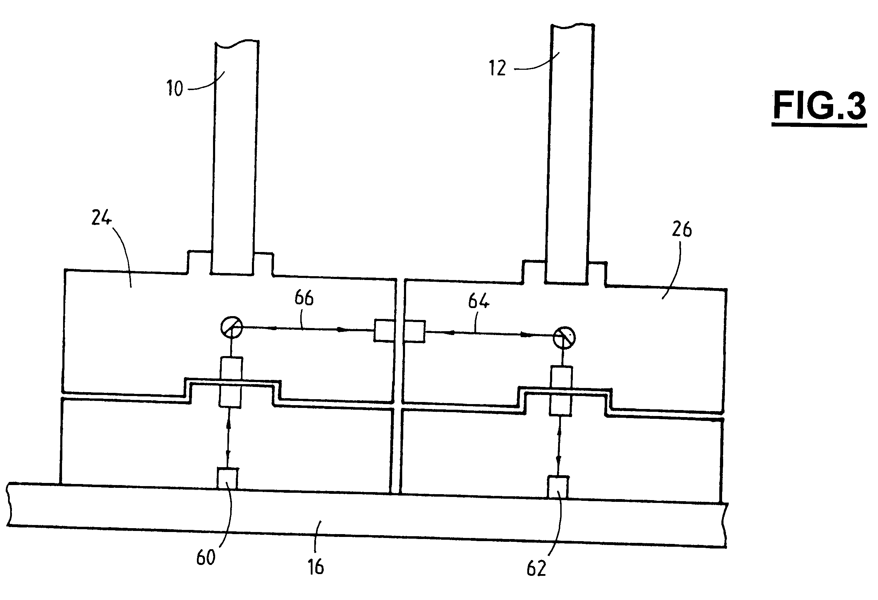

La figure 3 montre une disposition symétrique à celle de la figure 2 dans laquelle deux points de sortie optiques 60 et 62 de la carte mère 16 sont directement reliés par un chemin optique 64, 66 ménagé dans les fiches 24 et 26 associées aux cartes filles 10 et 12.

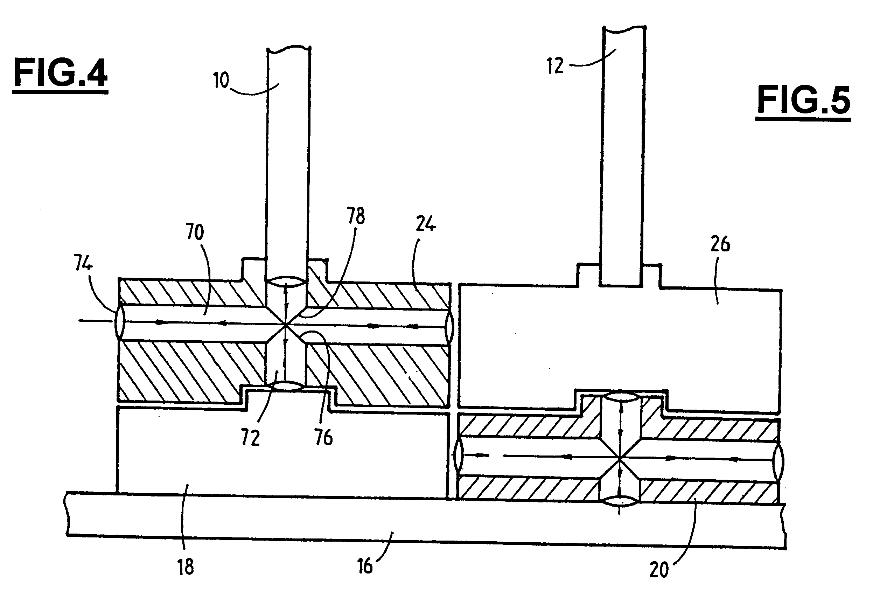

Les figures 4 et 5 montrent plus en détails un mode de réalisation de chemin optique, respectivement dans une fiche et dans une embase. Dans la fiche 24, les trajets optiques référencés 70 et 72 sont par exemple constitués par des évidements ou, de préférence, par un matériau transparent conducteur de la lumière tel qu'un matériau plastique noyé dans le matériau isolant électrique dont est faite la fiche. Les extrémités des trajets optiques 70 et 72 servant à la connexion optique avec les trajets optiques des composants voisins peuvent consister soit dans l'extrémité des éléments conducteurs de la lumière eux-mêmes, soit dans une lentille de focalisation telle que 74. De même, au point de croisement 76 des deux trajets optiques, on peut prévoir un composant optique localisé 78 autorisant le cheminement du faisceau lumineux selon les trajets 74 et 72 de manière déterminée. Il peut s'agir par exemple de miroirs semi-réfléchissants formant séparateurs de lumière 78. Comme on l'a déjà indiqué, le composant localisé 78 pourrait également être dynamique et permettre de modifier la liaison ou les liaisons possibles entre les deux trajets optiques. Comme le montre la figure 4, le trajet optique 72 débouche directement dans la tranche du support isolant de la carte fille 10 qui doit alors être au moins partiellement conducteur de la lumière. La figure 5 montre une disposition totalement similaire de réalisation de trajet optique dans l'embase 20.

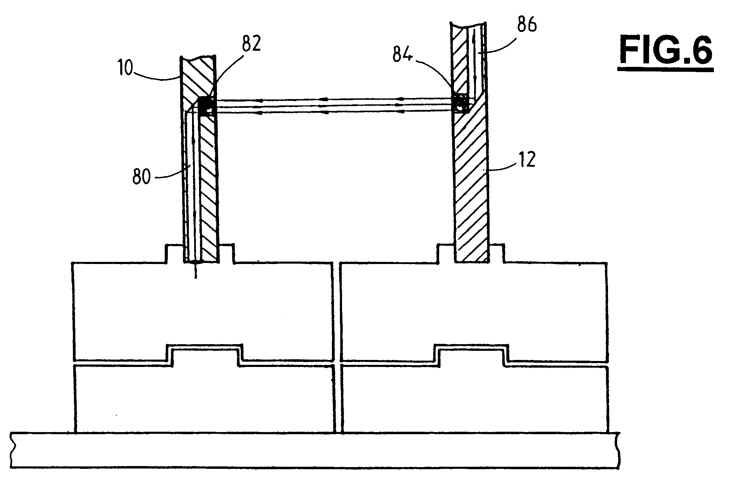

Dans la partie précédente de la description, on a toujours envisagé le cas où les liaisons optiques additionnelles entre les cartes filles étaient réalisées directement soit par l'intermédiaire des fiches, soit par l'intermédiaire des embases associées, soit encore par les fiches et les embases combinées. La figure 6 illustre un autre mode de mise en oeuvre des liaisons optiques additionnelles entre les cartes filles 10 et 12. Comme le montre la figure 6, cette liaison est une liaison directe entre les deux cartes filles. Pour cela, la carte fille 10 comporte un élément de guidage de la lumière 80 interne au support isolant de la carte fille et un élément conducteur optique 82 qui débouche dans la face principale du support de la carte fille 10. La carte fille 12 comprend en regard de la portion de conducteur optique 82 de la carte fille 10 un élément conducteur optique 84 qui débouche dans la face principale du support isolant de la carte fille 12. Cet élément conducteur de la lumière 84 est bien sûr relié à d'autres éléments conducteurs optiques, tels que 86, prévus dans la carte fille 12. On comprend qu'ainsi on établit une liaison optique directe entre la carte fille 10 et la carte fille 12, cette liaison étant de plus bidirectionnelle. Il va de soi qu'on peut prévoir à l'extrémité des conducteurs optiques 82 et 84 des composants optiques de focalisation du faisceau lumineux émis ou reçu.

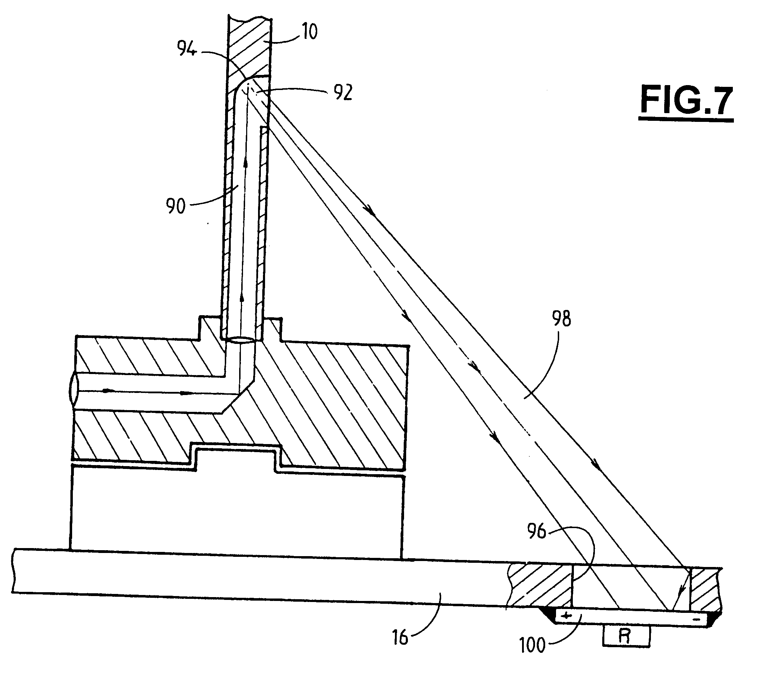

La figure 7 montre un exemple de liaison directe entre une carte fille, par exemple 10, et la carte mère 16 sans passer par les fiches ou les embases. Sur cette figure, le support isolant de la carte fille 10 comporte un trajet optique 90 qui se termine par un élément conducteur de la lumière 92 constitué par exemple par un évidement muni d'une partie réfléchissante 94 divergente. La carte mère 16 comporte elle-même un évidement 96 dans une zone dépourvue d'embase. L'évidement 96 est disposé de telle manière qu'il reçoive le faisceau lumineux 98 réfléchi par la portion réfléchissante 94 de la carte fille 10. En regard de l'orifice 96, on peut prévoir un composant localisé optique récepteur 100 qui peut être un composant opto-électronique.

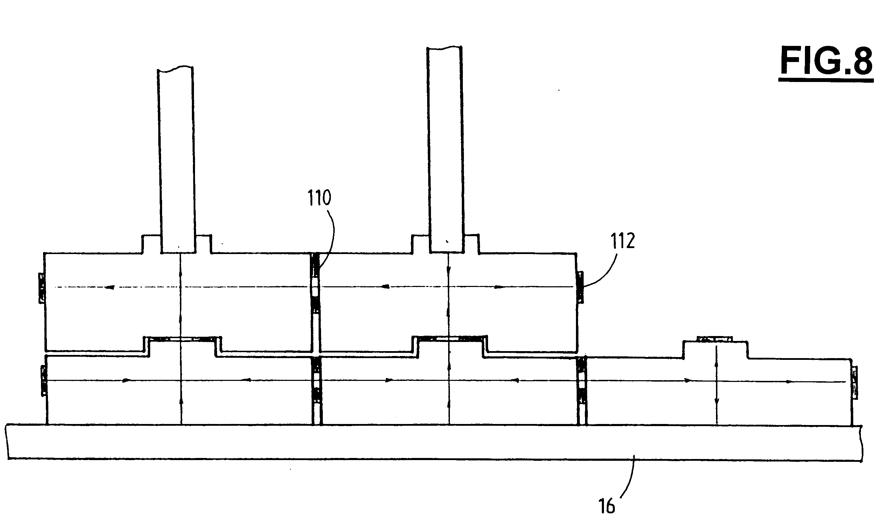

On comprend que, lors des manipulations des différentes cartes filles avec leur fiche pour les engager ou les retirer des embases associées à la carte mère 16, les extrémités des conducteurs optiques ménagés dans les fiches et éventuellement dans les embases risquent d'être altérées quant à leurs propriétés optiques. Il est intéressant de prévoir à l'extrémité de chaque chemin optique un élément de protection qui peut, par exemple, être constitué par un micro-volet mécanique ou un système de diaphragme qui peut s'ouvrir mécaniquement. Ces organes mécaniques illustrés sur la figure 8 peuvent prendre une première position ouverte, c'est par exemple le cas de l'élément de protection 110 sur la figure 8, ou une position fermée de protection comme l'élément de protection mécanique 112. Les éléments de protection des extrémités de chemin optique servent principalement de protection lorsque les fiches ne sont pas engagées sur une carte mère. On comprend que ces éléments de protection mécanique peuvent également servir d'obturateurs durant le fonctionnement normal du système d'interconnexion. Ce sera par exemple le cas des éléments de protection disposés dans une fiche ou dans une embase, elle-même située à l'extrémité d'un trajet optique. Les éléments de protection peuvent également servir d'obturateurs commandables si l'on veut se réserver la possibilité de supprimer de façon commandée la liaison optique entre les chemins optiques de deux fiches ou de deux embases.

## Revendications

**1.-** Système de transmission de signaux électriques et/ou optiques entre au moins deux cartes filles comprenant une carte mère présentant au moins deux embases pour établir des liaisons électriques et/ou optiques avec au moins deux fiches associées auxdites cartes filles afin d'établir des transmissions de signaux électriques et/ou optiques entre lesdites cartes filles via ladite carte mère et la solidarisation mécanique des cartes filles sur la carte mère, caractérisé en ce qu'il comprend en outre des moyens optiques additionnels pour établir des chemins optiques additionnels pour transmission directe de signaux optiques entre au moins deux éléments choisis dans le groupe comprenant : deux fiches, deux embases, deux cartes filles, une embase et une fiche ou une carte fille et la carte mère, par quoi les moyens optiques additionnels établissent entre au moins deux cartes filles une transmission de signaux optiques ne passant pas par ladite carte mère.

**2.-** Système de transmission selon la revendication 1, caractérisé en ce que lesdits moyens optiques additionnels comprennent des moyens pour établir au moins une liaison optique dans chaque fiche de carte fille et des moyens pour établir au moins une liaison optique entre deux embases.

**3.-** Système de transmission selon la revendication 1, caractérisé en ce que lesdits moyens optiques additionnels comprennent des moyens pour établir au moins un chemin optique dans chaque embase de la carte mère et des moyens pour établir au moins un chemin optique direct entre deux fiches.

**4.-** Système de transmission selon l'une quelconque des revendications 1 à 3, caractérisé en ce qu'au moins une partie du matériau isolant électrique d'une fiche est conducteur de la lumière et en ce que ladite fiche comporte des composants optiques localisés pour établir au moins un chemin optique dans ladite fiche.

**5.-** Système de transmission selon l'une quelconque des revendications 1 à 3, caractérisé en ce qu'au moins une partie du matériau isolant électrique d'une embase est conducteur de la lumière et en ce que ladite embase comporte au moins un composant optique localisé pour établir au moins un chemin optique dans ladite embase.

**6.-** Système de transmission selon l'une quelconque des revendications 1 à 3, caractérisé en ce qu'une pluralité d'embases adjacentes sont réalisées en un matériau isolant électrique comprenant au moins une partie conductrice de la lumière et en ce que chaque embase comprend au moins un composant optique localisé pour établir au moins un chemin optique entre lesdites embases et au moins un chemin optique vers chaque fiche.

**7.-** Système de transmission selon la revendication 1, caractérisé en ce que le support isolant électrique d'une carte fille est au moins en partie un matériau conducteur de la lumière et en ce que ladite carte fille comprend au moins un composant optique localisé pour définir au moins un chemin optique dans ledit matériau.

**8.-** Système de transmission selon la revendication 1, caractérisé en ce que au moins une carte fille comprend un composant optique localisé pour injecter un faisceau lumineux hors du plan du support isolant électrique de ladite carte fille, et en ce qu'au moins une autre carte fille comprend un composant optique localisé pour prélever ledit faisceau lumineux.

**9.-** Système de transmission selon la revendication 1, caractérisé en ce qu'au moins une carte fille comprend un composant optique localisé pour injecter ou recevoir un faisceau lumineux hors du plan du support isolant électrique de ladite carte fille et en ce que ladite carte mère comprend au moins un composant électrique localisé pour injecter ou recevoir ledit faisceau lumineux.

**10.-** Système de transmission selon l'une quelconque des revendications 1 à 9, caractérisé en ce qu'au moins une partie des extrémités des éléments optiques additionnels disposées aux interfaces de deux éléments mécaniquement séparés sont munies de dispositifs de protection amovibles vis-à-vis d'agents polluants des propriétés optiques.

**11.-** Système de transmission selon l'une quelconque des revendications 1 à 3, caractérisé en qu'une pluralité de fiches adjacentes sont réalisées en un matériau isolant électrique comprenant au moins une partie conductrice de la lumière et en ce que chaque fiche comprend au moins un composant optique localisé pour établir au moins un chemin optique entre lesdits fiches et au moins un chemin optique vers chaque embase.

**12.-** Système de transmission selon la revendication 1, caractérisé en que le support de la carte mère est au moins en partie un matériau conducteur de la lumière et en ce que ladite carte mère comprend au moins un composant optique localisé pour définir au moins un chemin optique dans ledit matériau.

**13.-** Système de transmission selon la revendication 1, caractérisé en qu'au moins une embase ou au moins une fiche comprend des moyens optiques pour établir deux chemins optiques se croisant et en ce qu'il comprend en outre dans ladite zone de croisement des moyens optiques commandables pour modifier le trajet du signal optique dans lesdits chemins optiques.
